# EUROPÄISCHE PATENTANMELDUNG

(11) **EP 3 726 941 A1**
(43) Veröffentlichungstag der Anmeldung: **21.10.2020**
(21) Anmeldenummer: 19169462.9
(22) Anmeldetag: 16.04.2019
(51) Int. Cl.: H05K 1/02, H01L 23/66

(54) **VERFAHREN ZUM ERZEUGEN EINES IMPEDANZKONTROLLIERTEN ÜBERGANGS VON EINEM ELEKTRISCHEN BAUTEIL ZU EINER GESCHIRMTEN HF-KABELVERBINDUNG UND VORRICHTUNG**

(71) Anmelder: Rosenberger Hochfrequenztechnik GmbH & Co. KG, 83413 Fridolfing (DE)
(72) Erfinder: Wollitzer, Michael, 83413 Fridolfing (DE); Sommerauer, Michael, 83317 Teisendorf (DE); Dandl, Christian, 83413 Fridolfing (DE)
(74) Vertreter: Zeitler Volpert Kandlbinder Patent- und Rechtsanwälte Partnerschaft mbB

(57) **Zusammenfassung**

Die Erfindung betrifft ein Verfahren zum Erzeugen eines impedanzkontrollierten Übergangs (2) von einem elektrischen Bauteil (3) zu einer geschirmten HF-Kabelverbindung (4), mit den folgenden Schritten: Verbinden eines Innenleiters (12) der geschirmten HF-Kabelverbindung (4) mittels einer Verbindung (15) mit einer Fläche (16) eines Signalleiters des elektrischen Bauteils (3); Aufbringen eines Dielektrikums (13) um die Verbindung (15) und den Innenleiter (12) der geschirmten HF-Kabelverbindung (4); und Aufbringen einer äußeren Schicht (14), welche das Dielektrikum (13) umschließt, zum Bilden eines Außenleiters (17), wobei der Außenleiter (17) mit einer Fläche (18) eines Bezugsleiters des elektrischen Bauteils (3) verbunden wird.

## Beschreibung

Die Erfindung bezieht sich auf ein Verfahren zum Erzeugen eines Übergangs von einem elektrischen Bauteil zu einer geschirmten Hochfrequenz-Kabelverbindung (HF-Kabelverbindung) und auf eine entsprechende Vorrichtung.

Für die hochfrequente Signalübertragung eignen sich vor allem Koaxialkabel. Dazu werden Koaxialkabel mit Signalübertragungspunkten auf elektrischen Bauteilen, wie z.B. Leiterplatten, verbunden. Die US 7,468,560 B2 zeigt einen elektrischen Übergang von einem Halbleiterbauelement zu einem Koaxialkabel.

In der US 2018/0098437 A1 ist ein elektrischer Übergang zwischen einer Kontaktstelle einer Leiterplatte und einem am Ende abisolierten vorgefertigten Micro-Koaxialkabel offenbart. Im Bereich der Abisolierung wird ein Isolator aufgebracht. Um den Außenleiter des vorgefertigten Micro-Koaxialkabels mit der elektrischen Masse der Leiterplatte zu verbinden, ist eine dicke Anhäufung von elektrisch leitfähigem Material auf der Leiterplatte vorgesehen. Alternativ ist der Außenleiter über eine Leitung elektrisch mit der Masse der Leiterplatte verbunden.

Die US 2016/0372440 A1 offenbart ein Verfahren für eine koaxiale Kabelbondverbindung (Coaxial Wire Bond: CWB).

Der Erfindung liegt die Aufgabe zugrunde, ein verbessertes Verfahren zur Erzeugung eines Übergangs von einem elektrischen Bauteil zu einer geschirmten HF-Kabelverbindung bereitzustellen. Insbesondere soll ein verbesserter Übergang eine breitbandigere Signalübertragung ermöglichen. Ebenso ist es eine Aufgabe der Erfindung, eine Vorrichtung mit einem verbesserten Übergang von einem elektrischen Bauteil zu einer geschirmten HF-Kabelverbindung bereitzustellen.

Diese Aufgabe wird durch den Gegenstand des unabhängigen Patentanspruchs 1 gelöst. Vorteilhafte Ausgestaltungen des erfindungsgemäßen Verfahrens sind Gegenstand von abhängigen Patentansprüchen und ergeben sich aus der nachfolgenden Beschreibung der Erfindung. Eine verbesserte Vorrichtung wird in Anspruch 12 beschrieben.

Demgemäß wird ein Verfahren zum Erzeugen eines impedanzkontrollierten Übergangs von einem elektrischen Bauteil zu einer geschirmten HF-Kabelverbindung bereitgestellt. Das Verfahren weist die folgenden Schritte auf:
- Verbinden eines Innenleiters der geschirmten HF-Kabelverbindung mittels einer Verbindung mit einer Fläche eines Signalleiters des elektrischen Bauteils,
- Aufbringen eines Dielektrikums um die Verbindung und den Innenleiter der geschirmten HF-Kabelverbindung, und
- Aufbringen einer äußeren Schicht, welche das Dielektrikum umschließt, zum Bilden eines Außenleiters, wobei der Außenleiter mit einer Fläche eines Bezugsleiters des elektrischen Bauteils verbunden wird.

Dadurch, dass der Übergang aufgrund des Aufbringens des Dielektrikums impedanzkontrolliert ausgebildet wird, kann durch die resultierend hohe Eingangsreflexionsdämpfung eine breitbandigere Signalübertragung zwischen dem elektrischen Bauteil und der geschirmten HF-Kabelverbindung erfolgen. Impedanzkontrolliert bedeutet dabei, dass sich im Übergangsbereich von geschirmter HF-Kabelverbindung und elektrischem Bauteil ein hinsichtlich der Minimierung der Reflexion optimierter Impedanzverlauf ausbildet. Zweckmäßigerweise sind die Impedanzen der geschirmten HF-Kabelverbindung, des elektrischen Bauteils und des Übergangsbereichs aufeinander abgestimmt. Dadurch können störende Reflexionen, welche sich ohne Anpassung der Impedanz bei der Signalübertragung ergeben würden, vermieden werden.

Eine Impedanzanpassung des Übergangs ist insbesondere dann erforderlich, wenn die Fläche des Signalleiters groß gegenüber dem Durchmesser des Innenleiters der geschirmten HF-Kabelverbindung ist.

Der impedanzkontrollierte Übergang soll insbesondere für den Hochfrequenz-Bereich (HF-Bereich) geeignet sein. Unter Hochfrequenz (HF) wird der Bereich von 5 MHz bis 5 THz verstanden.

Da nicht nur um den Innenleiter der geschirmten HF-Kabelverbindung sondern auch um die Verbindung ein Dielektrikum aufgebracht wird, kann mittels dem Aufbringen der äußeren Schicht, welche das Dielektrikum umschließt, eine elektromagnetische Abschirmung erreicht werden, welche eine geschlossene äußere Schirmung darstellt, und dementsprechend die Elektromagnetische-Verträglichkeit (EMV) verbessert. Dabei bedeutet die Schicht umschließt das Dielektrikum, dass die Schicht auf den gesamten mit dem Dielektrikum bedeckten Bereich aufgebracht wird. Dabei ist die Schicht vorzugsweise geschlossen. Insbesondere handelt es sich bei dem Aufbringen der Schicht um das Aufbringen einer dünnen elektrisch leitfähigen Schicht.

Die geschirmte HF-Kabelverbindung ist kein vorgefertigtes Koaxialkabel. Vielmehr wird die geschirmte HF-Kabelverbindung bei dem Verfahren zum Erzeugen eines impedanzkontrollierten Übergangs mit hergestellt. Der Innenleiter der geschirmten HF-Kabelverbindung kann dann an dem nicht an der Verbindung verbundenen Ende mit z.B. einem vorgefertigten Koaxialkabel, einer Kontaktfläche auf dem selben elektrischen Bauteil oder einer Kontaktfläche auf einem anderen elektrischen Bauteil verbunden sein.

Prinzipiell kann auch ein impedanzkontrollierter Übergang mit zwei oder mehreren parallelen Innenleitern hergestellt werden. Insbesondere eignet sich das erfindungsgemäße Verfahren auch für eine sogenannte Twinax-Struktur.

Die Reihenfolge der Schritte "Verbinden eines Innenleiters der geschirmten HF-Kabelverbindung mittels einer Verbindung mit einer Fläche eines Signalleiters des elektrischen Bauteils", "Aufbringen eines Dielektrikums um die Verbindung" und "Aufbringen eines Dielektrikums um den Innenleiter der geschirmten HF-Kabelverbindung" ist nicht festgelegt. Es kann zuerst der Innenleiter der geschirmten HF-Kabelverbindung mittels der Verbindung verbunden werden, danach das Dielektrikum um die Verbindung aufgebracht werden und anschließend das Dielektrikum um den Innenleiter der geschirmten HF-Kabelverbindung aufgebracht werden. Ebenso kann das Dielektrikum in einem Schritt aufgebracht werden. Es ist auch möglich, dass zuerst das Dielektrikum um die Verbindung aufgebracht wird, dann der Innenleiter der geschirmten HF-Kabelverbindung mit der Verbindung verbunden wird und anschließend das Dielektrikum um den Innenleiter der geschirmten HF-Kabelverbindung aufgebracht wird.

Bei dem elektrischen Bauteil kann es sich um aktive elektrische Bauteile, z.B. um eine integrierte Hochfrequenzschaltung mit einem Hochfrequenzverstärker, oder um passive elektrische Bauteile, z.B. um ein Koaxialkabel, handeln. Insbesondere kann es sich bei dem elektrischen Bauteil um eine Leiterplatte handeln. Mittels des erfindungsgemäßen Verfahrens werden reflexionsarme elektrische Anbindungen von Kabeln mit sehr kleinem Innenleiterdurchmesser an konventionell hergestellte Leiterplatten mit entsprechend großen Strukturgrößen möglich.

Der Signalleiter kann den Signalleiter einer koaxialen Leiterstruktur des elektrischen Bauteils darstellen. Insbesondere ist der Signalleiter als Signalleiter einer HF-Durchkontaktierung einer Leiterplatte oder als Signal-Streifenleiter einer HF-Streifenleiterstruktur ausgebildet.

Als Dielektrikum kann insbesondere Parylene verwendet werden. Denkbar sind aber auch andere dielektrische Beschichtungsmaterialien mit passender Permittivität.

Bei dem Aufbringen der äußeren Schicht kann es sich insbesondere um das Aufbringen einer äußeren Metallisierung handeln. Aufbringen einer äußeren Metallisierung bedeutet, dass eine Schicht aus einem Metall auf das Dielektrikum aufgebracht wird. Dabei ist die Schichtdicke des Metalls bevorzugt sehr viel kleiner als die Dicke des Dielektrikums um die Verbindung. Vorzugsweise ist die Schichtdicke der Schicht aus Metall gleichmäßig ausgebildet. Damit der so gebildete Außenleiter mit einem Bezugsleiter verbunden wird, kann es erforderlich sein, zuvor etwas von dem Dielektrikum in einem Bereich über einer Fläche des Bezugsleiters abzutragen.

Der Bezugsleiter kann als Referenzleiter ausgebildet sein. Dabei ist die räumliche Ausdehnung des Bezugsleiters prinzipiell beliebig. Der Bezugsleiter kann z.B. als Leitung, als breiter Bereich, als beliebig geformter Bereich oder in einer Form mit einer beliebigen dreidimensionalen Ausdehnung ausgebildet sein. Weiter kann der Bezugsleiter mit einem Massepotential, mit einem positiven Bezugspotential oder mit einem negativen Bezugspotential verbunden werden. Dabei kann sich das Bezugspotential zeitlich verändern.

Gemäß einer Ausführungsform des Verfahrens ist eine Erstreckung des Dielektrikums in radialer Richtung der geschirmten HF-Kabelverbindung an der Verbindung zu der Fläche des Signalleiters größer als eine Erstreckung des Dielektrikums in radialer Richtung der geschirmten HF-Kabelverbindung entlang der geschirmten HF-Kabelverbindung. Aufgrund der vergrößerten Erstreckung des Dielektrikums in radialer Richtung der geschirmten HF-Kabelverbindung an der Verbindung, also der vergrößerten Dicke des Dielektrikums an der Verbindung, ist der Abstand von der Fläche des Signalleiters des elektrischen Bauteils zu der äußeren Schicht, also z.B. der äußeren Metallisierung, vergrößert. Eine unerwünschte Parallelkapazität kann so zwischen der Fläche des Signalleiters und der äußeren Schicht vermieden bzw. verringert werden.

Werden auf dem Signalleiter sowohl eine Dielektrikumsschicht als auch eine äußere Metallschicht auf dem elektrischen Bauteil belassen, also nicht entfernt, so erzeugt die äußere Metallisierung, welche nur mit der Dicke der Dielektrikumsschicht von dem Signalleiter entfernt ist, eine Parallelkapazität. Dabei kann die Parallelkapazität bei Fehlanpassung das Signalübertragungsverhalten bei der Übertragung von Hochfrequenzsignalen stören, da die Parallelkapazität die Impedanz des Übergangs beeinflusst. Die Größe der Beeinflussung hängt von der Größe der Parallelkapazität ab. Die Parallelkapazität wird umso größer je dünner das Dielektrikum ist, je größer der Signalleiter ist und je größer das Verhältnis von dem Signalleiter zu dem Durchmesser des Innenleiters der geschirmten HF-Kabelverbindung ist. Dementsprechend kann man bei einer Vergrößerung der Dicke des Dielektrikums an der Verbindung eine Verkleinerung der Parallelkapazität erreichen.

Wird die Impedanz mittels der Dicke des Dielektrikums um die Verbindung entsprechend designt, kann man darauf verzichten die entsprechenden Stellen von der Metallisierung und möglicherweise auch dem Dielektrikum wieder zu befreien, um eine unerwünschte Impedanzänderung zu eliminieren. Dieses Entfernen würde einen zusätzlichen Prozessschritt erfordern und ist in vielen Fällen, z.B. bei hohen Packungsdichten, nicht praktikabel. Insofern wird der Einsatzbereich des erfindungsgemäßen Verfahrens erweitert.

Aufgrund der größeren Dicke des Dielektrikums um die Verbindung wird, bei gegebenem Haftverbund zwischen dem Dielektrikum um die Verbindung und dem Innenleiter sowie zwischen dem Dielektrikum um die Verbindung und dem elektrischen Bauteil, die mechanische Stabilität zwischen der geschirmten HF-Kabelverbindung und dem elektrischen Bauteil erhöht. Dies sorgt für eine Zugentlastung zwischen dem Innenleiter der geschirmten HF-Kabelverbindung und dem Signalleiter. Zudem sorgt dies für einen Knickschutz bei dem Innenleiter der geschirmten HF-Kabelverbindung.

Gemäß einer weiteren Ausführungsform des Verfahrens wird die Verbindung als eine direkte Verbindung, als ein Metallpin oder als ein Kontaktierungshügel zwischen dem Innenleiter und der Fläche des Signalleiters ausgebildet. Bei einer direkten Verbindung wird der Innenleiter der geschirmten HF-Kabelverbindung direkt mit der Fläche des Signalleiters verbunden. Der Innenleiter der geschirmten HF-Kabelverbindung wird in diesem Fall direkt mittels Löten, Bonden oder Schweißen mit der Fläche des Signalleiters verbunden. Dabei kann bei einer Lötverbindung ein Lötmittel verwendet werden. Alternativ kann bei einer Klebeverbindung ein leitfähiger Kleber verwendet werden.

Die Verbindung kann auch als Metallpin ausgebildet sein. In diesem Fall ist der Metallpin entweder kraftschlüssig mittels Presspassung, formschlüssig oder stoffschlüssig, z.B. mittels Löten, Bonden oder Schweißen, in einer Bohrung innerhalb der Leiterplatte eingepasst. Weiter kann die Verbindung als Kontaktierungshügel ("bump" bzw. "stud bump") ausgebildet sein.

Gemäß einer weiteren Ausführungsform des Verfahrens wird die geschirmte HF-Kabelverbindung senkrecht zu der Fläche des Signalleiters angeordnet. Aufgrund der senkrechten Ausrichtung der geschirmten HF-Kabelverbindung in Bezug auf die Fläche des Signalleiters, welcher flach ausgebildet ist, entsteht eine symmetrische Anordnung. Ebenfalls entsteht eine symmetrische Anordnung falls die geschirmte HF-Kabelverbindung entlang der gleichen Symmetrieachse verläuft wie der Metallpin oder der Kontaktierungshügel. Durch eine symmetrische Anordnung kann, insbesondere für einen senkrechten Durchstieg durch die Platine, gegenüber einer asymmetrischen Anordnung, die Impedanzanpassung weiter verbessert werden.

Alternativ kann die geschirmte HF-Kabelverbindung unter einem von 90° abweichenden Winkel zu der Fläche des Signalleiters angeordnet werden. Insbesondere kann der Winkel in einem Bereich von 20° bis 90°, bevorzugt in einem Bereich von 50° bis 90° oder besonders bevorzugt in einem Bereich von 70° bis 90° liegen.

Gemäß einer weiteren Ausführungsform des Verfahrens wird der Innenleiter der geschirmten HF-Kabelverbindung mittels Drahtbonden, Löten, Pressen, Lasererwärmen oder Reibschweißen an der Verbindung verbunden. Dabei kann die Verbindungsvariante nach den gewünschten Verbindungseigenschaften passend ausgewählt werden.

Gemäß einer weiteren Ausführungsform des Verfahrens wird ein erster Teil des Dielektrikums zuerst um die Verbindung auf das elektrische Bauteil aufgebracht. Danach wird ein zweiter Teil des Dielektrikums in einer Schicht um den Innenleiter der geschirmten HF-Kabelverbindung, auf den ersten Teil des Dielektrikums und/oder auf das elektrische Bauteil aufgebracht. Dabei können der erste Teil des Dielektrikums und der zweite Teil des Dielektrikums das gleiche Material aufweisen oder unterschiedliche Materialien aufweisen.

Vorteilhafterweise können der erste Teil des Dielektrikums und der zweite Teil des Dielektrikums in unterschiedlichen Schritten aufgebracht werden. Dies hat den Vorteil, dass der erste Teil des Dielektrikums und der zweite Teil des Dielektrikums mit unterschiedlichen Methoden aufgebracht werden können. Unterschiedliche Methoden sind hier z.B. die Vergusstechnik oder die Sprühtechnik. Beispielsweise wird der erste Teil des Dielektrikums als Vergussmasse um die Verbindung auf das elektrische Bauteil aufgebracht. Der zweite Teil des Dielektrikums kann als Schicht um den Innenleiter der geschirmten HF-Kabelverbindung, auf den ersten Teil des Dielektrikums und auf das elektrische Bauteil, beispielsweise durch Resublimation aus der Gasphase (Chemical Vapour Deposition (CVD) Verfahren), aufgetragen werden.

Alternativ kann ein zweiter Teil des Dielektrikums in einer Schicht um den Innenleiter der geschirmten HF-Kabelverbindung und auf das elektrische Bauteil aufgebracht werden. Danach wird der erste Teil des Dielektrikums um die Verbindung auf den zweiten Teil des Dielektrikums aufgebracht.

Gemäß einer weiteren Ausführungsform des Verfahrens wird der erste Teil des Dielektrikums mittels einer Vergusstechnik oder mittels eines additiven Fertigungsverfahrens aufgebracht. Bei der Vergusstechnik wird eine Vergussmasse um die Verbindung auf das elektrische Bauteil aufgebracht. Hierbei ist eine hochpräzise Dosierung der Menge an Vergussmasse nötig. Nach dem Aufbringen wird die Vergussmasse getrocknet und/oder ausgehärtet. Ein additives Fertigungsverfahren ist beispielsweise der 3D-Druck.

Gemäß einer weiteren Ausführungsform des Verfahrens wird bei der Vergusstechnik eine Oberfläche des elektrischen Bauteils strukturiert, um den Lotoseffekt auszunutzen und damit den ersten Teil des Dielektrikums platziert um die Verbindung aufzubringen. Dabei bedeutet platziert aufbringen, dass die Vergussmasse nicht auf der Oberfläche des elektrischen Bauteils verläuft, sondern örtlich begrenzt in dem gewünschten Bereich der Oberfläche aufgebracht wird. Als Lotoseffekt wird die geringe Benetzbarkeit einer Oberfläche bezeichnet. Wird die Oberfläche an bestimmten Stellen des elektrischen Bauteils strukturiert, so kann der Lotoseffekt ausgenutzt werden, damit die Vergussmasse aus Dielektrikum nicht in den strukturierten Bereich läuft.

Gemäß einer weiteren Ausführungsform des Verfahrens wird die Oberfläche mittels eines Laserstrahls, mittels eines Elektronenstrahls, mittels eines chemischen Verfahrens oder mittels eines mechanischen Verfahrens strukturiert. Vorteilhafterweise eignet sich sowohl die Bearbeitung der Oberfläche des elektrischen Bauteils mittels eines Laserstrahls als auch mittels eines Elektronenstrahls um die Oberfläche zu strukturieren, damit der Lotoseffekt ausgenutzt werden kann. Ebenfalls eignen sich auch chemische oder mechanische Verfahren zum Strukturieren der Oberfläche, damit der Lotoseffekt ausgenutzt werden kann.

Gemäß einer weiteren Ausführungsform des Verfahrens wird bei der Vergusstechnik eine Maske an einer Oberfläche des elektrischen Bauteils um die Verbindung von der Verbindung beabstandet aufgebracht, um den ersten Teil des Dielektrikums platziert um die Verbindung aufzubringen. Mittels der Maske kann die Vergussmasse aus Dielektrikum platziert aufgebracht werden, ohne dass die Vergussmasse verläuft. Unter dem platzierten Aufbringen wird ein in räumlicher Hinsicht präzises Aufbringen verstanden. Die Maske kann beispielsweise mittels Fotolack realisiert werden.

Gemäß einer weiteren Ausführungsform des Verfahrens wird der erste Teil des Dielektrikums bei dem Aufbringen um die Verbindung als eine nach außen konische Form, eine nach außen gewölbte Form oder eine nach außen kreiszylindrische Form ausgebildet. Vorteilhafterweise lässt sich nicht nur mittels der Dicke des Dielektrikums sondern auch mit der Form des Dielektrikums um die Verbindung die Impedanz des Übergangs beeinflussen. Dementsprechend kann die gewünschte Form des Dielektrikums gewählt werden.

Weiter wird eine Vorrichtung mit einem elektrischen Bauteil, einer geschirmten HF-Kabelverbindung und einem impedanzkontrollierten Übergang von dem elektrischen Bauteil zu der geschirmten HF-Kabelverbindung bereitgestellt, wobei ein Innenleiter der geschirmten HF-Kabelverbindung mittels einer Verbindung mit einer Fläche eines Signalleiters des elektrischen Bauteils verbunden ist, wobei ein Dielektrikum um die Verbindung und den Innenleiter der geschirmten HF-Kabelverbindung aufgebracht ist, und wobei eine äußere Schicht, welche das Dielektrikum umschließt, zum Bilden eines Außenleiters aufgebracht ist, und der Außenleiter mit einer Fläche eines Bezugsleiters des elektrischen Bauteils verbunden ist.

Der Übergang ist impedanzkontrolliert ausgebildet. Dadurch kann eine breitbandige Signalübertragung zwischen dem elektrischen Bauteil und der geschirmten HF-Kabelverbindung erfolgen. Störende Reflexionen, welche sich ohne Anpassung der Impedanz bei der Signalübertragung beim Übergang ergeben würden, werden vermieden.

Gemäß einer Ausführungsform der Vorrichtung ist eine Erstreckung des Dielektrikums in radialer Richtung der geschirmten HF-Kabelverbindung an der Verbindung zu der Fläche des Signalleiters größer als eine Erstreckung des Dielektrikums in radialer Richtung der geschirmten HF-Kabelverbindung entlang der geschirmten HF-Kabelverbindung. Wegen der größeren Erstreckung, d.h. der größeren Dicke, des Dielektrikums an der Verbindung ist der Abstand von der Fläche des Signalleiters des elektrischen Bauteils zu der äußeren Schicht größer als der Abstand von dem Innenleiter der geschirmten HF-Kabelverbindung zu der äußeren Schicht der geschirmten HF-Kabelverbindung. Eine unerwünschte Parallelkapazität, welche eine Impedanzanpassung des Übergangs und somit einen reflexionsarmen Übergang von dem elektrischen Bauteil zu der geschirmten HF-Kabelverbindung verhindert, kann so vermieden werden.

Gemäß einer weiteren Ausführungsform der Vorrichtung ist die Verbindung als eine direkte Verbindung, als ein Metallpin oder als ein Kontaktierungshügel zwischen dem Innenleiter und der Fläche des Signalleiters ausgebildet. Dabei können der Metallpin und/oder der Kontaktierungshügel in axialer Richtung einen unterschiedlichen Durchmesser aufweisen. Dabei kann der Durchmesser auf der Seite, welche mit dem Innenleiter der geschirmten HF-Kabelverbindung verbunden ist, kleiner als der Durchmesser auf der Seite, welche an das elektrische Bauteil grenzt, ausgebildet werden.

Gemäß einer weiteren Ausführungsform der Vorrichtung ist das elektrische Bauteil eine Leiterplatte. Weiter ist der Signalleiter ein Signalleiter einer HF-Durchkontaktierung durch die Leiterplatte oder ein Signal-Streifenleiter einer HF-Streifenleiterstruktur auf der Leiterplatte.

Die Leiterplatte kann aus mehreren Schichten aufgebaut sein.

Die HF-Durchkontaktierung durch die Leiterplatte umfasst den Signalleiter, eine dielektrische Schicht um diesen Signalleiter und einen Bezugsleiter um die dielektrische Schicht. Dabei erstreckt sich diese koaxiale Anordnung ganz oder teilweise durch die Leiterplatte. Der Bezugsleiter der HF-Durchkontaktierung kann in einer geschlossenen Form um den Signalleiter der HF-Durchkontaktierung und die dielektrische Schicht der HF-Durchkontaktierung ausgebildet sein. Alternativ kann der Bezugsleiter der HF-Durchkontaktierung als mehrere separate Durchkontaktierungen ausgebildet sein. In diesem Fall ist die Anordnung quasikoaxial. Diese separaten Durchkontaktierungen brauchen nicht komplett um den Signalleiter der HF-Durchkontaktierung verteilt sein, sie müssen lediglich so um den Signalleiter der HF-Durchkontaktierung angeordnet sein, dass eine Schirmungswirkung entsteht. Die separaten Durchkontaktierungen können auf einer Kreisform, auf einer rechteckigen Form oder auf einer quadratischen Form um den Signalleiter der HF-Durchkontaktierung angeordnet werden. Die separaten Durchkontaktierungen sind jedenfalls so angeordnet, dass eine gute Schirmwirkung und eine angepasste Impedanz in der Durchkontaktierung vorliegt.

Die HF-Streifenleiterstruktur umfasst den Signal-Streifenleiter. Weiter kann die HF-Streifenleiterstruktur zwei Bezugsleiter aufweisen, welche sich parallel auf beiden Seiten des Signal-Streifenleiters erstrecken. Dabei können sich sowohl der Signal-Streifenleiter als auch die beiden Bezugsleiter der HF-Streifenleiterstruktur auf der Oberfläche der Leiterplatte oder auf einer inneren Schicht der Leiterplatte erstrecken. Die HF-Streifenleiterstruktur kann beispielsweise einen Microstreifenleiter (mit einem Signal-Streifenleiter auf der Oberfläche der Leiterplatte und einem Bezugsleiter auf der Unterseite der Leiterplatte), eine Koplanarleitung (mit zwei Bezugsleitern um den Signal-Streifenleiter auf der Oberfläche der Leiterplatte und einem Bezugsleiter auf der Unterseite der Leiterplatte) oder eine eingebettete Streifenleitung (mit einem in die Leiterplatte eingebetteten Signal-Streifenleiter und einem Bezugsleiter auf der Oberseite der Leiterplatte und einem Bezugsleiter auf der Unterseite der Leiterplatte) aufweisen.

Die für das vorgeschlagene Verfahren beschriebenen Ausführungsformen und Merkmale gelten für die vorgeschlagene Vorrichtung entsprechend und umgekehrt.

Weitere mögliche Implementierungen der Erfindung umfassen auch nicht explizit genannte Kombinationen von zuvor oder im Folgenden beschriebenen Merkmalen. Dabei können auch Einzelaspekte als Verbesserungen oder Ergänzungen zu der jeweiligen Grundform der Erfindung hinzugefügt werden.

Die Erfindung wird im Folgenden anhand der Zeichnungen näher erläutert. Diese zeigen in
Fig. 1 eine schematische Schnittansicht einer erfindungsgemäßen Vorrichtung mit einem impedanzkontrollierten Übergang zwischen einem elektrischen Bauteil und einer geschirmten HF-Kabelverbindung;
Fig. 2A bis 2F einzelne Schritte eines erfindungsgemäßen Verfahrens zum Erzeugen eines impedanzkontrollierten Übergangs;
Fig. 3 eine schematische Schnittansicht einer weiteren erfindungsgemäßen Vorrichtung mit einem impedanzkontrollierten Übergang zwischen einem elektrischen Bauteil und einer geschirmten HF-Kabelverbindung;
Fig. 4A bis 4J einzelne Schritte eines weiteren erfindungsgemäßen Verfahrens zum Erzeugen eines impedanzkontrollierten Übergangs;
Fig. 5 eine schematische Schnittansicht einer weiteren erfindungsgemäßen Vorrichtung mit einem impedanzkontrollierten Übergang zwischen einem elektrischen Bauteil und einer geschirmten HF-Kabelverbindung; und
Fig. 6 ein Ablaufdiagramm des erfindungsgemäßen Verfahrens.

In den Figuren sind gleiche oder funktionsgleiche Elemente mit denselben Bezugszeichen versehen worden. Ferner sollte beachtet werden, dass die Darstellungen in den Figuren nicht notwendigerweise maßstabsgerecht sind.

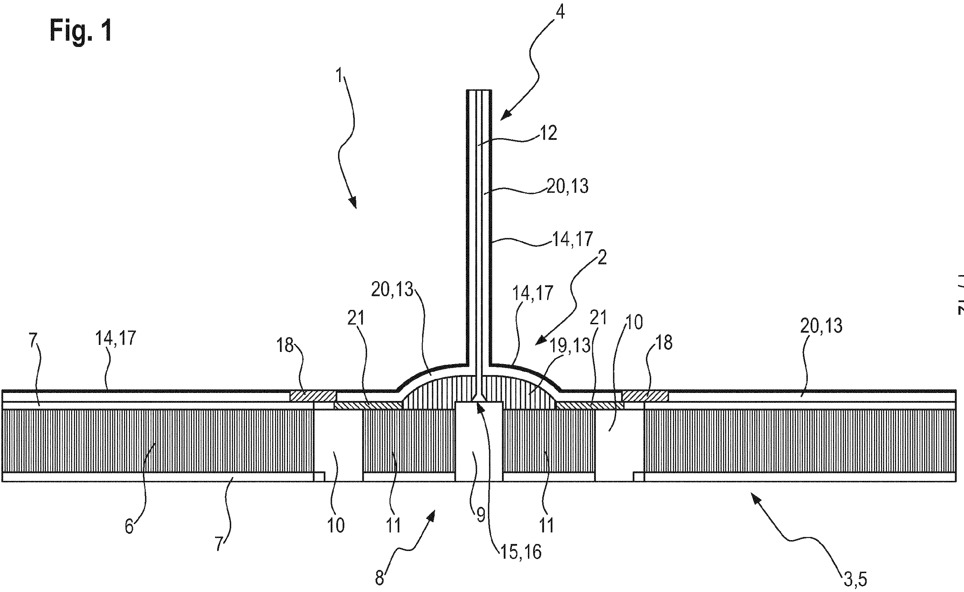

Fig. 1 zeigt eine schematische Schnittansicht einer erfindungsgemäßen Vorrichtung 1 mit einem impedanzkontrollierten Übergang 2 zwischen einem elektrischen Bauteil 3 und einer geschirmten HF-Kabelverbindung 4. Das elektrische Bauteil 3 ist als Leiterplatte 5 ausgebildet. Die Leiterplatte 5 umfasst eine Isolationsschicht 6 und Leiterbahnen 7, welche auf beiden Seiten der Isolationsschicht 6 angeordnet sind. Die Leiterplatte 5 weist weiter eine HF-Durchkontaktierung 8 auf. Dabei steht das HF für Hochfrequenz. Die HF-Durchkontaktierung 8 umfasst einen Signalleiter 9 und bevorzugt koaxial und rotationssymmetrisch dazu angeordnet einen Bezugsleiter 10. Der Bezugsleiter 10 kann geschlossen ausgebildet sein oder mehreren einzelne Elemente aufweisen. Zwischen dem Signalleiter 9 der HF-Durchkontaktierung 8 und dem Bezugsleiter 10 der HF-Durchkontaktierung 8 ist ein Isolator 11 angeordnet.

Die Leiterbahnen 7 können auch als Bezugsflächen, d.h. insbesondere als Masseflächen, ausgebildet sein. Weiter kann die Leiterplatte 5 mehrere Schichten aufweisen. Insbesondere kann die Leiterplatte 5 mehrere Isolationsschichten 6 umfassen.

Die geschirmte HF-Kabelverbindung 4 weist einen Innenleiter 12, ein Dielektrikum 13 und eine äußere Schicht 14 auf. Die äußere Schicht 14 ist als äußere Metallisierung ausgebildet. Der Innenleiter 12 ist mittels einer direkten Verbindung 15 mit einer Fläche 16 des Signalleiters der Leiterplatte 5 verbunden. Der Signalleiter ist in diesem Fall der Signalleiter 9 der HF-Durchkontaktierung 8.

Wie die Fig. 1 zeigt, ist ein Dielektrikum 13 um die Verbindung 15 und den Innenleiter 12 der geschirmten HF-Kabelverbindung 4 angeordnet. Das Dielektrikum 13 umschließt die Verbindung 15 und den Innenleiter 12 der geschirmten HF-Kabelverbindung 4. Insbesondere umschließt das Dielektrikum 13 die Verbindung 15 und den Innenleiter 12 der geschirmten HF-Kabelverbindung 4 vollständig. Das Dielektrikum 13 erstreckt sich ebenfalls über die Leiterplatte 5. Über dem Dielektrikum 13 ist eine Schicht 14 aufgebracht. Die Schicht 14 bildet einen Außenleiter 17. Der Außenleiter 17 wird über eine Fläche 18 mit einer Leiterbahn 7 elektrisch verbunden. Die Leiterbahn 7 ist wiederum mit dem Bezugsleiter 10 der HF-Durchkontaktierung 8 elektrisch verbunden.

Die Dicke des Dielektrikums 13 an der Verbindung 15 ist größer als die Dicke des Dielektrikums 13 bei der geschirmten HF-Kabelverbindung 4. Dabei ist ein erster Teil 19 des Dielektrikums 13 um die Verbindung 15 auf die Leiterplatte 5 aufgebracht. Ein zweiter Teil 20 des Dielektrikums 13 ist in einer Schicht über dem Innenleiter 12 der geschirmten HF-Kabelverbindung 4, über dem ersten Teil 19 des Dielektrikums 13 und über einem weiteren Teil der Leiterplatte 5 aufgebracht.

Dadurch, dass die Dicke des Dielektrikums 13 an der Verbindung 15 mittels des ersten Teils 19 des Dielektrikums 13 vergrößert ist, ergibt sich ein größerer Abstand zwischen der Fläche 16 des Signalleiters 9 und der äußeren Schicht 14. Je kleiner der beschriebene Abstand ist, desto größer wird die Parallelkapazität, welche sich aufgrund des Signalleiters 9, der äußeren Schicht 14 und dem dazwischenliegenden Dielektrikum 13 bildet. Da die Parallelkapazität die Impedanz beeinflusst, sind die Parallelkapazität und weitere Parameter, wie z.B. die Größe der Fläche 16 des Signalleiters 9 und das Verhältnis von der Fläche 16 des Signalleiters 9 zu dem Durchmesser des Innenleiters 12 der geschirmten HF-Kabelverbindung 4, entsprechend durch bauliche Maßnahmen der Vorrichtung 1 so zu gestalten, dass sich ein impedanzkontrollierter Übergang 2 ergibt.

Der erste Teil 19 des Dielektrikums 13 ist daher von der Position und der Menge her genau aufzubringen. Dies kann erreicht werden, indem der erste Teil 19 des Dielektrikums 13 mittels einer Vergusstechnik aufgebracht ist. Dazu wird eine Oberfläche 21 auf der Leiterplatte 5, d.h. ein Teilbereich der gesamten Oberfläche der Leiterplatte 5, strukturiert. Dies kann mittels eines Laserstrahls oder mittels eines Elektronenstrahls erreicht werden. Alternativ kann eine Strukturierung der Oberfläche 21 auch mittels eines chemischen Verfahrens oder mittels eines mechanischen Verfahrens erfolgen.

Die strukturierte Oberfläche 21 wirkt dabei auf den ersten Teil 19 des Dielektrikums 13 abweisend. Dabei wird der sogenannte Lotoseffekt ausgenutzt. Genauer wird der erste Teil 19 des Dielektrikums 13 als Vergussmasse mit einer gewissen Viskosität aufgebracht. Dabei ist die Oberflächenenergie der strukturierten Oberfläche 21 so eingestellt, dass die Adhäsionskräfte gering gegenüber der Oberflächenspannung der Vergussmasse sind und die strukturierte Oberfläche 21 nicht benetzt. Durch Einstellen der Menge der Vergussmasse, der Wahl deren Viskosität und Oberflächenspannung sowie Einstellen des Kontaktwinkels zum elektrischen Bauteil 3 kann die gewünschte Geometrie erzielt werden. Dadurch wird die Vergussmasse genau in der gewünschten Form und genau an der gewünschten Position, d.h. in dem gewünschten Bereich um die Verbindung 15, positioniert, bis die Vergussmasse, d.h. der ersten Teil 19 des Dielektrikums 13, ausgehärtet ist. Wie in der Fig. 1 dargestellt, weist der erste Teil 19 des Dielektrikums 13 eine nach außen gewölbte Form auf.

In Abhängigkeit der Oberflächenenergie des elektrischen Bauteils 3 kann entweder die Oberfläche 21 oder der Flächenbereich der sich innerhalb der Oberfläche 21 befindet, benetzbar oder nicht benetzbar gestaltet werden. Alternativ kann die Oberfläche 21 und der Flächenbereich der sich innerhalb der Oberfläche 21 befindet jeweils strukturiert werden wobei die Benetzbarkeit im Flächenbereich innerhalb der Oberfläche 21 stärker benetzbar ist.

Die genaue Kontrolle der Vergussmasse, welche den ersten Teil 19 des Dielektrikums 13 darstellt, ermöglicht eine Kontrolle der Impedanzanpassung des zu kontaktierenden HF-Kanals.

Bei der in der Fig. 1 gezeigten Vorrichtung 1 ist die geschirmte HF-Kabelverbindung 4 senkrecht zu der Fläche 16 des Signalleiters 9 angeordnet. Alternativ könnte die geschirmte HF-Kabelverbindung 4 aber auch unter einem Winkel kleiner als 90° von der Fläche 16 des Signalleiters 9 angeordnet werden.

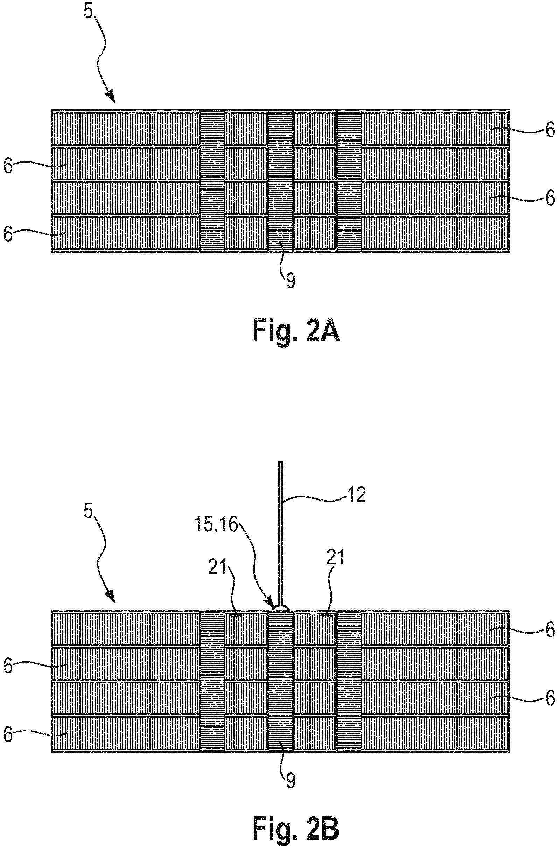

Die Fig. 2A bis 2F zeigen einzelne Schritte eines erfindungsgemäßen Verfahrens zum Erzeugen eines impedanzkontrollierten Übergangs 2. Der impedanzkontrollierte Übergang 2 entspricht dem der Vorrichtung 1 aus Fig. 1. Allerdings wird in den Fig. 2A bis 2F eine Leiterplatte 5 mit mehreren Isolationsschichten 6 dargestellt.

In einem ersten Schritt wird eine Leiterplatte 5 bereitgestellt (siehe Fig. 2A).

Danach wird in einem zweiten Schritt ein Bereich der Oberfläche der Leiterplatte 5 strukturiert. Es wird demnach eine strukturierte Oberfläche 21, welche beabstandet von dem Bereich an dem die Verbindung 15 vorgesehen ist, gebildet.

In einem dritten Schritt wird ein Innenleiter 12 der geschirmten HF-Kabelverbindung 4 mittels einer direkten Verbindung 15 mit einer Fläche 16 des Signalleiters 9 der Leiterplatte 5 elektrisch verbunden (siehe Fig 2B). Die elektrische Verbindung kann insbesondere über Drahtbonden, Löten, Pressen, Lasererwärmen oder Reibschweißen sowie Kleben erfolgen.

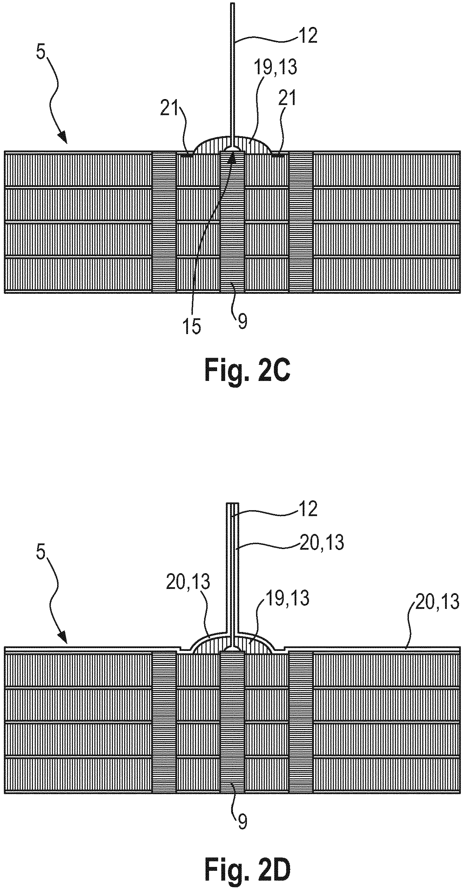

In einem vierten Schritt wird der erste Teil 19 des Dielektrikums 13 um die Verbindung 15 auf die Leiterplatte 5 aufgebracht. Dabei wird der erste Teil 19 des Dielektrikums 13 so platziert, dass er innerhalb der strukturierten Oberfläche 21 angeordnet ist (siehe Fig. 2C).

Nachdem der erste Teil 19 des Dielektrikums 13 ausgehärtet ist, wird in einem fünften Schritt ein zweiter Teil 20 des Dielektrikums 13 auf den Innenleiter 12 der geschirmten HF-Kabelverbindung 4, auf den ersten Teil 19 des Dielektrikums 13 und auf einen weiteren Teil der Leiterplatte 5 in einer Schicht aufgebracht (siehe Fig. 2D).

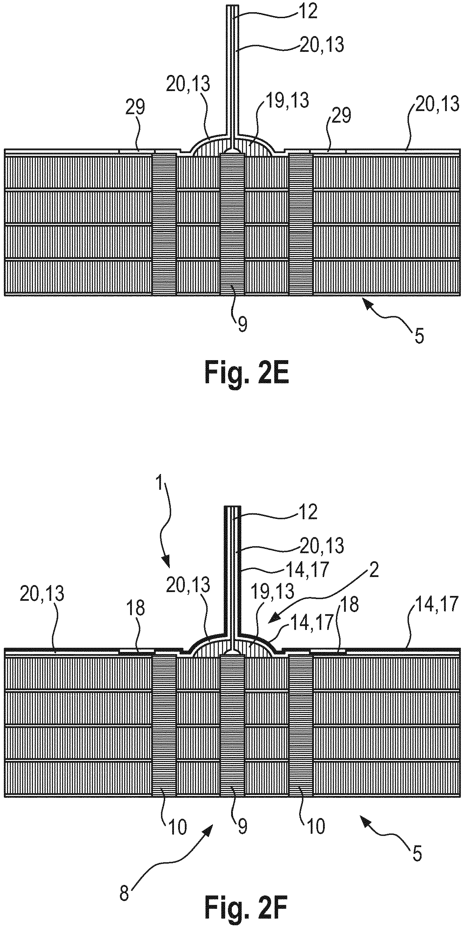

In einem sechsten Schritt wird der zweite Teil 20 des Dielektrikums 13 an zumindest einer Stelle 29 beseitigt, damit später ein Kontakt zu einer Fläche 18 eines Bezugsleiters 10 gebildet werden kann (siehe Fig. 2E).

Anschließend erfolgt in einem siebten Schritt das Aufbringen der äußeren Schicht 14. Dabei ist die äußere Schicht 14 als äußere Metallisierung ausgebildet, um einen Außenleiter 17 auszubilden. Über die Fläche 18 ist der Außenleiter 17 elektrisch mit dem Bezugsleiter 10 der HF-Durchkontaktierung 8 verbunden (siehe Fig. 2F).

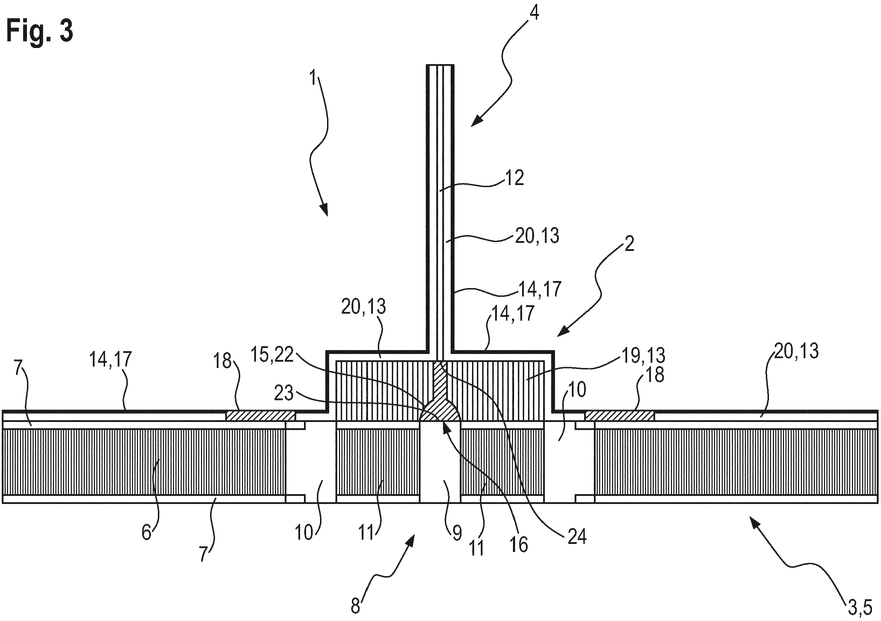

Fig. 3 zeigt eine weitere schematische Schnittansicht einer erfindungsgemäßen Vorrichtung 1 mit einem impedanzkontrollierten Übergang 2 zwischen einem elektrischen Bauteil 3 und einer geschirmten HF-Kabelverbindung 4. Die Vorrichtung 1 der Fig. 3 unterscheidet sich von der Vorrichtung 1 der Fig. 1, indem in der Vorrichtung 1 der Fig. 3 die Verbindung 15 als Kontaktierungshügel 22 ausgebildet ist, keine strukturierte Oberfläche 21 vorhanden ist und der erste Teil 19 des Dielektrikums 13 eine nach außen kreiszylindrische Form aufweist. Alternativ könnte der erste Teil 19 des Dielektrikums 13 auch eine quaderförmige Form aufweisen.

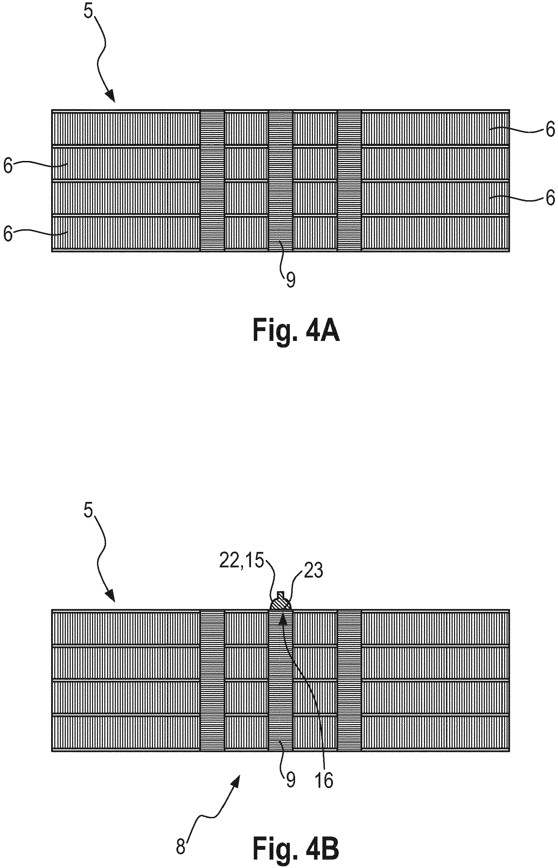

Die Fig. 4A bis 4J zeigen einzelne Schritte eines erfindungsgemäßen Verfahrens zum Erzeugen eines impedanzkontrollierten Übergangs 2. Der impedanzkontrollierte Übergang 2 entspricht dem der Vorrichtung 1 aus Fig. 3. Allerdings wird in den Fig. 4A bis 4J eine Leiterplatte 5 mit mehreren Isolationsschichten 6 dargestellt.

In einem ersten Schritt wird eine Leiterplatte 5 bereitgestellt (siehe Fig. 4A).

Danach wird in einem zweiten Schritt ein Kontaktierungshügel 22 an einem ersten Ende 23 mit dem Signalleiter 9 der HF-Durchkontaktierung 8 elektrisch und mechanisch verbunden. Der Kontaktierungshügel 22 stellt die Verbindung 15 zwischen dem Innenleiter 12 der geschirmten HF-Kabelverbindung 4 und der Fläche 16 des Signalleiters 9 der Leiterplatte 5 dar (siehe Fig. 4B).

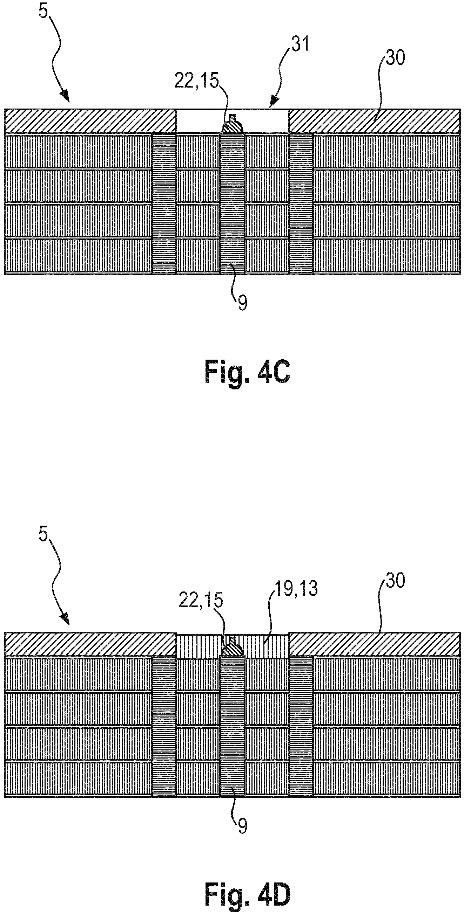

In einem dritten Schritt wird eine Maske 30 auf die Leiterplatte 5 aufgebracht. Dabei wird ein Bereich 31 um den Kontaktierungshügel 22 freigelassen (siehe Fig. 4C).

Eine Vergussmasse, welche den ersten Teil 19 des Dielektrikums 13 bildet, wird in einem vierten Schritt in den freien Bereich 31 um den Kontaktierungshügel 22 eingefüllt. Die Vergussmasse wird zumindest so hoch in den freien Bereich 31 eingefüllt, dass der Kontaktierungshügel 22 vollständig bedeckt ist. Dadurch ist der erste Teil 19 des Dielektrikums 13 um die Verbindung 15, d.h. um den Kontaktierungshügel 22, auf die Leiterplatte 5 aufgebracht (siehe Fig. 4D). Dabei kann der erste Teil 19 des Dielektrikums 13 mittels der Maske 30 so platziert sein, dass er kreiszylinderförmig um den Kontaktierungshügel 22 angeordnet ist.

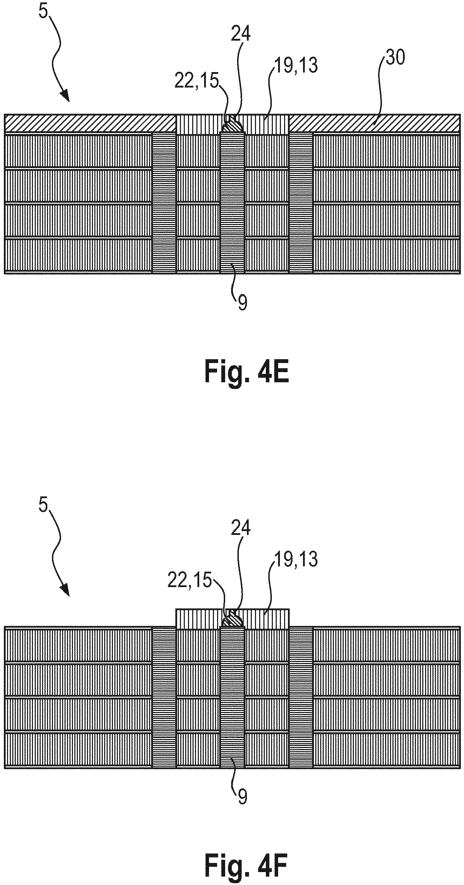

Nachdem der erste Teil 19 des Dielektrikums 13 ausgehärtet ist, kann die Maske 30 und der erste Teil 19 des Dielektrikums 13 in einem fünften Schritt abgeschliffen werden, so dass ein zweites Ende 24 des Kontaktierungshügels 22 freiliegt (siehe Fig. 4E).

Danach kann die Maske 30 in einem sechsten Schritt entfernt werden (siehe Fig. 4F).

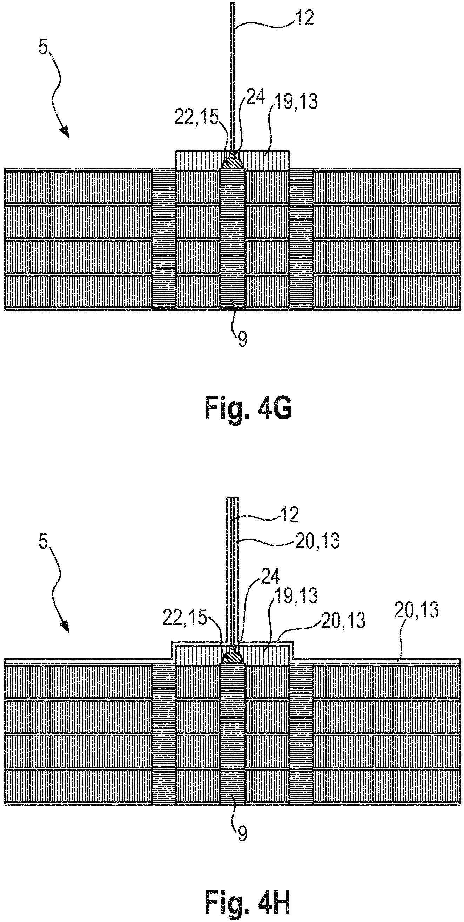

In einem siebten Schritt wird das zweite Ende 24 des Kontaktierungshügels 22 mit dem Innenleiter 12 der geschirmten HF-Kabelverbindung 4 elektrisch und mechanisch verbunden. Die elektrische Verbindung kann insbesondere über Drahtbonden, Löten, Pressen, Lasererwärmen oder Reibschweißen erfolgen (siehe Fig. 4G).

Anschließend wird in einem achten Schritt ein zweiter Teil 20 des Dielektrikums 13 auf den Innenleiter 12 der geschirmten HF-Kabelverbindung 4, auf den ersten Teil 19 des Dielektrikums 13 und auf einen weiteren Teil der Leiterplatte 5 in einer Schicht aufgebracht (siehe Fig. 4H).

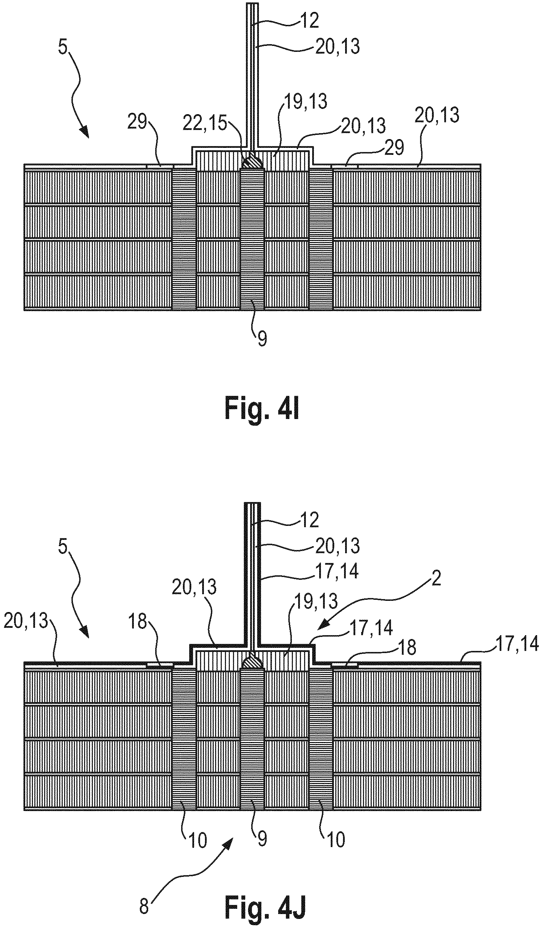

In einem neunten Schritt wird der zweite Teil 20 des Dielektrikums 13 an zumindest einer Stelle 29 beseitigt, damit später ein Kontakt zu einer Fläche 18 eines Bezugsleiters 10 gebildet werden kann (siehe Fig. 4I).

Danach erfolgt in einem zehnten Schritt das Aufbringen der äußeren Schicht 14. Dabei ist die äußere Schicht 14 als äußere Metallisierung ausgebildet, um einen Außenleiter 17 auszubilden. Über die Fläche 18 ist der Außenleiter 17 elektrisch mit dem Bezugsleiter 10 der HF-Durchkontaktierung 8 verbunden (siehe Fig. 4J).

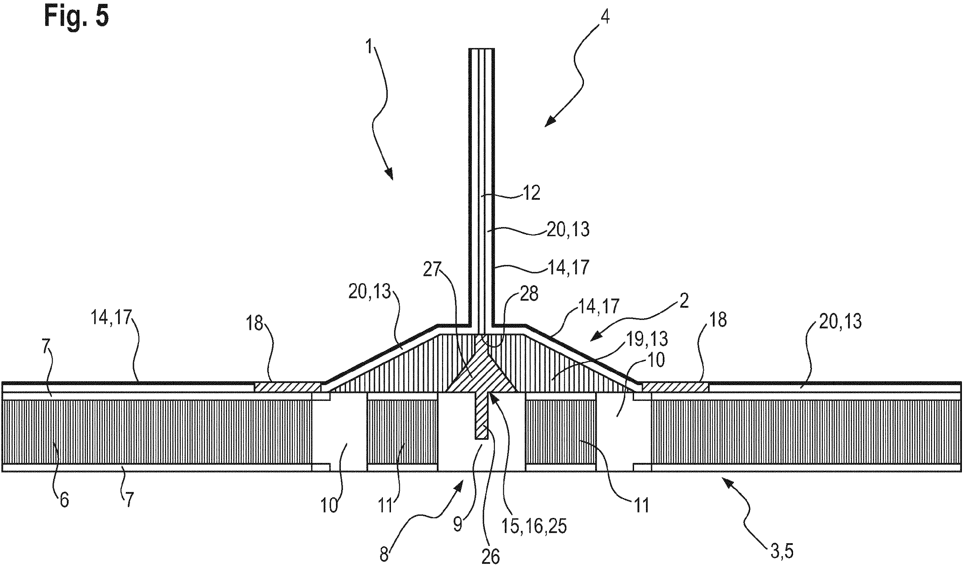

Fig. 5 zeigt eine weitere schematische Schnittansicht einer erfindungsgemäßen Vorrichtung 1 mit einem impedanzkontrollierten Übergang 2 zwischen einem elektrischen Bauteil 3 und einer geschirmten HF-Kabelverbindung 4. Die Vorrichtung 1 der Fig. 5 unterscheidet sich von der Vorrichtung 1 der Fig. 3, indem in der Vorrichtung 1 der Fig. 5 die Verbindung 15 als Metallpin 25 ausgebildet ist. Zudem weist der erste Teil 19 des Dielektrikums 13 eine nach außen konische Form auf. Der innerhalb der Leiterplatte 5 liegende Abschnitt 26 des Metallpins 25 dient zur mechanischen und elektrischen Befestigung mit dem Signalleiter 9 der HF-Durchkontaktierung 8. Um den außerhalb der Leiterplatte 5 liegende Abschnitt 27 des Metallpins 25 ist der erste Teil 19 des Dielektrikums 13 angeordnet.

Die Vorrichtung 1 aus Fig. 5 wird hergestellt, indem zuerst ein Metallpin 25 mit einem innerhalb der Leiterplatte 5 liegenden Abschnitt 26 mit dem Signalleiter 9 der HF-Durchkontaktierung 8 elektrisch und mechanisch verbunden wird. Anschließend wird der außerhalb der Leiterplatte 5 liegende Abschnitt 27 des Metallpins 25 von dem ersten Teil 19 des Dielektrikums 13 umhüllt. Dazu wird eine Vergusstechnik mit einer Maske angewendet, so dass sich eine konische Form für den ersten Teil 19 des Dielektrikums 13 ergibt. Danach wird der ausgehärtete Teil 19 des Dielektrikums 13 planarisiert, d.h. abgeschliffen, so dass ein Kontaktpunkt 28 des Metallpins 25 freiliegt. Dieser Kontaktpunkt 28 wird mit dem Innenleiter 12 der geschirmten HF-Kabelverbindung 4 elektrisch verbunden. Die elektrische Verbindung kann insbesondere über Drahtbonden, Löten, Pressen, Lasererwärmen oder Reibschweißen erfolgen. Im Anschluss wird ein zweiter Teil 20 des Dielektrikums 13 auf den Innenleiter 12 der geschirmten HF-Kabelverbindung 4, auf den ersten Teil 19 des Dielektrikums 13 und auf einen weiteren Teil der Leiterplatte 5 in einer Schicht aufgebracht. Der zweite Teil 20 des Dielektrikums 13 wird an zumindest einer Stelle für einen Kontakt mit einer Fläche 18 eines Bezugsleiters beseitigt. Anschließend erfolgt die äußere Metallisierung, durch das Aufbringen einer äußeren Schicht 14. Damit ist dann der Außenleiter 17 elektrisch mit dem Bezugsleiter 10 der HF-Durchkontaktierung 8 verbunden.

Alternativ kann der erste Teil 19 des Dielektrikums 13 auch mit einem additiven Prozess, insbesondere einem 3D-Druckverfahren, hergestellt werden. In diesem Fall ist der erste Teil 19 des Dielektrikums 13 präzise um die Verbindung 15 zu platzieren. Ebenso ist es möglich den Metallpin 25 in einem additiven Prozess, insbesondere einem 3D-Druckverfahren, herzustellen.

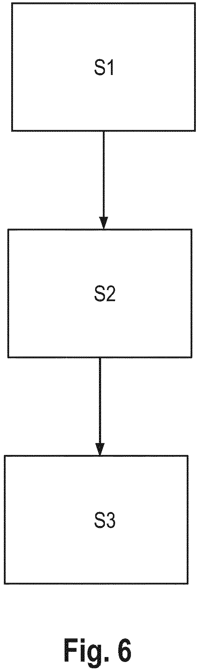

Fig. 6 zeigt ein Ablaufdiagramm des erfindungsgemäßen Verfahrens zum Erzeugen eines impedanzkontrollierten Übergangs 2 von einem elektrischen Bauteil 3 zu einer geschirmten HF-Kabelverbindung 4. Das Verfahren weist die folgenden Schritte auf. In einem ersten Schritt S1 wird der Innenleiter 12 der geschirmten HF-Kabelverbindung 4 mittels einer Verbindung 15 mit einer Fläche 16 eines Signalleiters des elektrischen Bauteils 3 verbunden. In einem zweiten Schritt S2 wird das Dielektrikum 13 um die Verbindung 15 und den Innenleiter 12 der geschirmten HF-Kabelverbindung 4 aufgebracht. In einem dritten Schritt S3 wird die äußere Schicht 14 auf das Dielektrikum 13 zum Bilden eines Außenleiters 17 aufgebracht. Dabei wird der Außenleiter 17 mit einer Fläche 18 eines Bezugsleiters des elektrischen Bauteils 3 verbunden.

Wie zu den Figuren 1 bis 11 näher beschrieben, können die Verfahrensschritte S1 und S2 bzw. auch die Teilschritte von S2 "Aufbringen des Dielektrikums 13 um die Verbindung 15" und "Aufbringen des Dielektrikums 13 um den Innenleiter 12 der geschirmten HF-Kabelverbindung 4" in der zeitlichen Abfolge variieren.

Insbesondere wird an der Verbindung 15 eine größere Dicke für das Dielektrikum 13 vorgesehen als bei der geschirmten HF-Kabelverbindung 4. Mittels der Dicke des Dielektrikums 13 an der Verbindung 15 kann die Impedanz des Übergangs 2 beeinflusst werden.

Das erfindungsgemäße Verfahren ist insbesondere geeignet für das Bonden auf Platinen, das Bonden auf integrierte Schaltungen, das Bonden auf HF-Kabel mit großen Dimensionen, das Packaging von Halbleiterbauelementen und das Verbinden von einem Halbleiterbauelement mit einem weiteren Halbleiterbauelement.

### Bezugszeichenliste

- 1: Vorrichtung
- 2: impedanzkontrollierter Übergang
- 3: elektrisches Bauteil
- 4: geschirmte HF-Kabelverbindung
- 5: Leiterplatte
- 6: Isolationsschicht
- 7: Leiterbahn
- 8: HF-Durchkontaktierung
- 9: Signalleiter der HF-Durchkontaktierung
- 10: Bezugsleiter der HF-Durchkontaktierung
- 11: Isolator
- 12: Innenleiter der geschirmten HF-Kabelverbindung
- 13: Dielektrikum
- 14: äußere Schicht
- 15: Verbindung
- 16: Fläche des Signalleiters
- 17: Außenleiter
- 18: Fläche des Bezugsleiters
- 19: erster Teil des Dielektrikums
- 20: zweiter Teil des Dielektrikums
- 21: Oberfläche
- 22: Kontaktierungshügel
- 23: erstes Ende des Kontaktierungshügels
- 24: zweites Ende des Kontaktierungshügels
- 25: Metallpin
- 26: innerhalb der Leiterplatte liegender Abschnitt
- 27: außerhalb der Leiterplatte liegender Abschnitt
- 28: Kontaktpunkt
- 29: Stelle
- 30: Maske
- 31: Bereich

## Patentansprüche

1. Verfahren zum Erzeugen eines impedanzkontrollierten Übergangs (2) von einem elektrischen Bauteil (3) zu einer geschirmten HF-Kabelverbindung (4), mit den Schritten:
- Verbinden eines Innenleiters (12) der geschirmten HF-Kabelverbindung (4) mittels einer Verbindung (15) mit einer Fläche (16) eines Signalleiters des elektrischen Bauteils (3),
- Aufbringen eines Dielektrikums (13) um die Verbindung (15) und den Innenleiter (12) der geschirmten HF-Kabelverbindung (4), und
- Aufbringen einer äußeren Schicht (14), welche das Dielektrikum (13) umschließt, zum Bilden eines Außenleiters (17), wobei der Außenleiter (17) mit einer Fläche (18) eines Bezugsleiters des elektrischen Bauteils (3) verbunden wird.

2. Verfahren nach Anspruch 1, wobei eine Erstreckung des Dielektrikums (13) in radialer Richtung der geschirmten HF-Kabelverbindung (4) an der Verbindung (15) zu der Fläche (16) des Signalleiters größer ist als eine Erstreckung des Dielektrikums (13) in radialer Richtung der geschirmten HF-Kabelverbindung (4) entlang der geschirmten HF-Kabelverbindung (4).

3. Verfahren nach Anspruch 1 oder 2, wobei die Verbindung (15) als eine direkte Verbindung, als ein Metallpin (25) oder als ein Kontaktierungshügel (22) zwischen dem Innenleiter (12) und der Fläche (16) des Signalleiters ausgebildet wird.

4. Verfahren nach einem der vorhergehenden Ansprüche, wobei die geschirmte HF-Kabelverbindung (4) senkrecht zu der Fläche (16) des Signalleiters angeordnet wird.

5. Verfahren nach einem der vorhergehenden Ansprüche, wobei der Innenleiter (12) der geschirmten HF-Kabelverbindung (4) mittels Drahtbonden, Löten, Pressen, Lasererwärmen oder Reibschweißen an der Verbindung (15) verbunden wird.

6. Verfahren nach einem der vorhergehenden Ansprüche, wobei ein erster Teil (19) des Dielektrikums (13) zuerst um die Verbindung (15) auf das elektrische Bauteil (3) aufgebracht wird und ein zweiter Teil (20) des Dielektrikums (13) danach in einer Schicht um den Innenleiter (12) der geschirmten HF-Kabelverbindung (4), auf den ersten Teil (19) des Dielektrikums (13) und/oder auf das elektrische Bauteil (3) aufgebracht wird.

7. Verfahren nach Anspruch 6, wobei der erste Teil (19) des Dielektrikums (13) mittels einer Vergusstechnik oder mittels eines additiven Fertigungsverfahrens aufgebracht wird.

8. Verfahren nach Anspruch 7, wobei bei der Vergusstechnik eine Oberfläche (21) des elektrischen Bauteils (3) strukturiert wird, um den Lotoseffekt auszunutzen und damit den ersten Teil (19) des Dielektrikums (13) platziert um die Verbindung (15) aufzubringen.

9. Verfahren nach Anspruch 8, wobei die Oberfläche (21) mittels eines Laserstrahls, mittels eines Elektronenstrahls, mittels eines chemischen Verfahrens oder mittels eines mechanischen Verfahrens strukturiert wird.

10. Verfahren nach Anspruch 7, wobei bei der Vergusstechnik eine Maske an einer Oberfläche des elektrischen Bauteils (3) um die Verbindung (15) von der Verbindung (15) beabstandet aufgebracht wird, um den ersten Teil (19) des Dielektrikums (13) platziert um die Verbindung (15) aufzubringen.

11. Verfahren nach einem der Ansprüche 6 bis 10, wobei der erste Teil (19) des Dielektrikums (13) bei dem Aufbringen um die Verbindung (15) als eine nach außen konische Form, eine nach außen gewölbte Form oder eine nach außen kreiszylindrische Form ausgebildet wird.

12. Vorrichtung (1) mit einem elektrischen Bauteil (3), einer geschirmten HF-Kabelverbindung (4) und einem impedanzkontrollierten Übergang (2) von dem elektrischen Bauteil (3) zu der geschirmten HF-Kabelverbindung (4),
wobei ein Innenleiter (12) der geschirmten HF-Kabelverbindung (4) mittels einer Verbindung (15) mit einer Fläche (16) eines Signalleiters des elektrischen Bauteils (3) verbunden ist,
wobei ein Dielektrikum (13) um die Verbindung (15) und den Innenleiter (12) der geschirmten HF-Kabelverbindung (4) aufgebracht ist, und
wobei eine äußere Schicht (14), welche das Dielektrikum (13) umschließt, zum Bilden eines Außenleiters (17) aufgebracht ist, und der Außenleiter (17) mit einer Fläche (18) eines Bezugsleiters des elektrischen Bauteils (3) verbunden ist.

13. Vorrichtung nach Anspruch 12, wobei eine Erstreckung des Dielektrikums (13) in radialer Richtung der geschirmten HF-Kabelverbindung (4) an der Verbindung (15) zu der Fläche (16) des Signalleiters größer ist als eine Erstreckung des Dielektrikums (13) in radialer Richtung der geschirmten HF-Kabelverbindung (4) entlang der geschirmten HF-Kabelverbindung (4).

14. Vorrichtung nach Anspruch 12 oder 13, wobei die Verbindung (15) als eine direkte Verbindung, als ein Metallpin (25) oder als ein Kontaktierungshügel (22) zwischen dem Innenleiter (12) und der Fläche (16) des Signalleiters ausgebildet ist.

15. Vorrichtung nach einem der Ansprüche 12 bis 14, wobei das elektrische Bauteil (3) eine Leiterplatte (5) ist und der Signalleiter ein Signalleiter (9) einer HF-Durchkontaktierung (8) durch die Leiterplatte (5) oder ein Signal-Streifenleiter einer HF-Streifenleiterstruktur auf der Leiterplatte (5) ist.
